Europäisches Patentamt

European Patent Office

Office européen des brevets

(19)

(11) Veröffentlichungsnummer: **0 085 117**
A1

(12) # EUROPÄISCHE PATENTANMELDUNG

(21) Anmeldenummer: 82100587.3

(22) Anmeldetag: 28.01.82

(51) Int. Cl.³: **G 11 C 7/00**
G 11 C 8/00, G 06 F 13/00

(43) Veröffentlichungstag der Anmeldung:
10.08.83 Patentblatt 83/32

(84) Benannte Vertragsstaaten:
AT CH DE FR GB IT LI SE

(71) Anmelder: Kienzle Apparate GmbH
Heinrich-Hertz-Strasse Postfach 1650
D-7730 Villingen-Schwenningen(DE)

(72) Erfinder: Adams, Jürgen
Am Mühlweiher 1 Ortsteil Tannheim
D-7730 Villingen-Schwenningen(DE)

(54) Schaltungsanordnung zur Sicherung von Daten in volatilen Schreib-Lese-Speichern (RAM).

(57) Die Verwendung eines flüchtigen Schreib-Lese-Speichers (RAM) zur Speicherung von Tarifdaten und variablen Kontrollzählerdaten in einem Taxameter bringt erhebliche Vorteile, wenn es gelingt, eine Schaltungsanordnung zur permanenten Absicherung der in einem RAM abgelegten Daten zu finden. Die erfindungs gemäße Schaltungsanordnung zur Lösung der Aufgabe gibt an, die Signalleitung (16) zwischen dem Mikrocomputersystem (1) und einem volatilen Schreib-Lese-Speicher (RAM) (10) über eine Steuerschaltung (13) zu führen, durch welche im plombierten Zustand des Taxameters eine permanent wirksame Unterdrückung von Einschreibbefehlen einstellbar ist. Damit sind die dort abgelegten Daten durch keinerlei Störsignale mehr vom Mikrocomputersystem (1) beeinflußbar. Die Betriebsspannungsversorgung des RAM (10) ist durch eine Schaltung (20 bis 26) unter Einbeziehung einer Pufferbatterie (23) und eines Pufferkondensators (24) gesichert.

FIG. 1

EP 0 085 117 A1

**0085117**

26.1.1982
o73 sche zw
Akte 1755

— 1 —

**Schaltungsanordnung zur Sicherung von Daten in volatilen Schreib-Lese-Speichern (RAM)**

Die Erfindung betrifft eine Schaltungsanordnung zur Sicherung von Daten, insbesondere von Tarifdaten und variablen Kontrolldaten in als flüchtige (volatile) Speicher ausgebildeten Schreib-Lese-Speichern (RAM) im Zusammenwirken mit einem mittels Pufferelementen gegen Versorgungsspannungseinbrüche geschützten Mikrocomputersystem eines Taxameters gegen Manipulation und Verlust oder unerlaubte Modifikation der gespeicherten Informationen.

Im wesentlichen besteht das Mikrocomputersystem eines Taxameters ganz allgemein aus einer Verbindung eines Mikroprozessors mit Speichern, Ein-Ausgabe-Elementen und Versorgungsbausteinen, die als System zusammengefaßt anhand eines vorgebbaren Programmes aufgrund der Eingabe von Weg- und/oder Zeitsignalen entscheiden, rechnen, anzeigen und Daten speichern kann. Eine verbreitete Ausführungsform ist der MOS-Mikroprozessor (z. B. Intel 8o49), der beispielsweise mit einer 8 Bit Wortlänge arbeitet im Gegensatz zu bipolaren Ausführungsformen. Als Teil des Mikrocomputersystems dient der Mikroprozessor oder CPU der Verarbeitung von Daten nach einer vorgebbaren Regel. Die Anweisungen für letztere sind in einem Festwertspeicher oder ROM (Read-Only-Memory) als so bezeichnete Befehle abgelegt und stellen das systeminterne Arbeitsprogramm dar. Informationen werden einmal in den Festwertspeicher (ROM) eingegeben und bleiben dann permanent erhalten. Die Funktion des ROM bleibt darauf beschränkt, daß der Speicherinhalt auslesbar ist. Im Anwendungsfall dient das ROM daher vornehmlich der Programmspeicherung. Das ROM muß aber bei jeder Änderung der Informationen gegen ein neues mit entsprechend geänderten Daten programmiertes ROM ausgetauscht werden. Solchen Änderungen sind beim Anwendungsfall in Taxametern von Zeit zu Zeit auch die Tarifdaten, die die Basis für die Berechnung eines Fahrpreises bilden, unterworfen. In bekannten Taxametern hat man die geänderten Tarifdaten in einen separaten, austauschbaren, programmierbaren ROM (PROM) eingegeben und zu gegebenem Zeitpunkt der Wirksamkeit des neuen Tarifs gegen den bisherigen Baustein (PROM) ausgetauscht. Diese Verfahrensweise ist bei häufigem Tarifwechsel selbstredend mit erheblichem Aufwand verbunden.

Weiter ist im Mikrocomputersystem ein Schreib-Lese-Speicher (RAM) vorgesehen für die Verarbeitung variabler Daten. Da in vorteilhafter Weise Informationen beliebig in das RAM eingelesen und wieder ausgelesen werden können, eignet sich diese Speicherart vorzüglich für die Datenspeicherung bzw. Datenzwischenspeicherung, wobei jedoch darauf zu achten ist, daß die Speisespannung nicht verloren geht, da mit einem Spannungseinbruch die Informationen verfälscht werden oder verloren gehen können.

Es ist daher bei Einspeicherung von Informationen in als flüchtige Speicher ausgebildeten Schreib-Lese-Speichern (RAM) zur Datensicherung unerläßlich, geeignete Maßnahmen vorzusehen, die in Abhängigkeit von Netzausfällen oder Absinken von Versorgungsspannungen unter einen vorgegebenen Wert eine Absicherungseinrichtung aktivieren, die den Erhalt der Informationen im RAM gewährleistet.

Eine bekannte Schaltungsanordnung zur Überbrückung von Netzausfällen besteht darin, daß dem RAM-Bereich beispielsweise eine Pufferbatterie zugeordnet ist, die die gespeicherten Informationen vorübergehend rettet. Es hat sich jedoch herausgestellt, daß darüber hinaus z. B. bei Netzausfall aufgrund von Kapazitäten oder Induktivitäten im Computersystem oder dem Netzteil undefinierte Spannungsverhältnisse entstehen, welche die im Schreib-Lese-Speicher (RAM) abgelegten Informationen verfälschen können. Neben der Absicherung der Versorgungsspannung für den RAM-Bereich mittels einer Pufferbatterie ist also darüber hinaus zum Schutz der Informationen im RAM eine weitere Maßnahme erforderlich, die insbesondere alle bei Netzausfall im System entstehenden undefinierten Spannungsimpulse, die sich als Störimpulse auswirken können, von der Einwirkung auf den RAM-Bereich fernhalten.

In diesem Zusammenhang ist gemäß der DE-PS 28 03 202 eine Schaltungsanordnung zur Datensicherung von in als flüchtige (volatile) Speicher ausgebildeten Schreib-Lese-Speichern (RAM) eingespeicherten Informationen bei Netzausfall oder absinkender Versorgungsspannung angegeben. Als Maßnahme zur Sicherung der Information im RAM bei Spannungsausfall oder - Absinken unter einen Minimalwert der Versorgungsspannung - ist eine Spannungsüberwachungsschaltung vorgesehen, die im Sicherungsfall, also ausschließlich bei Spannungsabfall in der angezeigten Art, die Versorgung des RAM-Bereiches mit Betriebspannung aus einem Ladungsspeicher oder Langzeitspeicher eines Entkopplungsnetzwerkes übernimmt. Das Entkopplungsnetzwerk steuert dann zusätzlich eine RAM-Einschreibsperrschaltung an, wodurch jegliche Informationsänderung im RAM-Bereich unterbunden ist, bevor überhaupt Störimpulse vorhanden sind. Zusammengefaßt dient diese bekannte Einrichtung also ausschließlich der Sicherung von Informationen im RAM bei Spannungsausfall des Computersystems.

Im Normalbetrieb eines Gerätes, gemeint ist bei korrekten Betriebsspannungsverhältnissen, bildet die bekannte Einrichtung keinen ausreichenden Schutz beispielsweise für Tarifdaten und/oder Kontrolldaten in einem RAM eines Taxametergerätes, da durch irgendwelche Systemstörungen oder Manipulationen eine Einspeisung von fehlerhaften Informationen in das RAM denkbar wäre.

Aufgabe der Erfindung ist es, eine Schaltungsanordnung zur permanenten Absicherung von Daten, insbesondere von Tarifdaten und Kontrolldaten in einem volatilen Schreib-Lese-Speicher (RAM) eines Taxameters zu entwickeln, wobei die Maßnahmen zur Absicherung ausschließlich durch autorisierten Eingriff in die Schaltungsanordnung aufhebbar sind.

Diese Aufgabe wird bei der Schaltungsanordnung der eingangs genannten Art erfindungsgemäß gelöst durch eine in die Signalleitung zwischen dem Mikrocomputersystem und dem Schreib-Lese-Speicher (RAM) einbezogene Steuerschaltung, mittels welcher im kalibrierten Zustand des Gerätes eine Unterdrückung von Einschreib-Befehlen einstellbar ist, derart daß der Erhalt der abgelegten Daten im RAM gewährleistet ist.

Die Vorteile einer Anwendung eines als volatiler Speicher ausgebildeten Schreib-Lese-Speichers (RAM) ganz allgemein für eine Datenspeicherung sind nicht übersehbar. Sie liegen insbesondere in der Eigenschaft des RAM, daß auf relativ kostengünstiger Basis mit diesem Bauelement ein Speichermittel zur Verfügung steht, in das auf einfache Weise beliebig oft Informationen ein- und ausgelesen werden können. Diese Fähigkeit kommt im Anwendungsfall beim Taxameter in der Eigenschaft als Tarifdaten- und Kontrolldatenspeicher einem entsprechenden Einsatz sehr entgegen. Da jedoch RAM's als Speichermittel mit allen Daten-, Adress- und Steuerleitungen mit einem Mikroprozessor-System in Verbindung stehen, muß über zusätzliche Schaltungsmaßnahmen sichergestellt werden, daß ungewollte Informationen aus dem System sowohl aufgrund eines Störungsfalles als auch durch versuchte Manipulation nicht eine Veränderung der abgelegten Daten im RAM verursachen können. Mit der in die Schreib-Signalleitung zwischen dem Mikrocomputersystem und dem RAM einbezogenen Steuerschaltung ist eine totale oder partiell vorwählbare Unterdrückung von Einschreibbefehlen einstellbar. Durch eine Schaltungsanordnung zum Unterbinden der Beschreibemöglichkeit des RAM für beispielsweise Tarifdaten und mit einer gleichzeitig wirksamen Entkopplung der Betriebsspannung des Systems und Pufferung der Versorgungsspannung des RAM während des normalen Betriebszustandes eines Taxameters wird ohne großen Aufwand erreicht, daß die im RAM abgelegten Daten durch keinerlei unkontrollierte Störeffekte beeinflußbar sind. Bei einer gleichzeitigen Verwendung des RAM für eine Einspeicherung von Tarifdaten und variablen Kontrollzählerdaten enthält die Steuerschaltung Maßnahmen, mittels welchen Teile des RAM,beispielsweise gekennzeichnet durch einen besonderen Adressbereich, für das Einschreiben von Informationen sperrbar sind, so daß eine Datenabfrage stets auslösbar ist, jede Einflußnahme im Sinne einer Datenmodifikation für den gekennzeichneten Speicherteil wirkungslos bleibt. Durch die Maßnahme einer gesteuerten Unterbindung der Einschreibmöglichkeit in das RAM ist es während des Normalbetriebes eines Taxameters möglich, den Informationsinhalt des an sich volatilen Speichers absolut abzusichern.

Um schließlich die Eigenschaft des Einlesens von Informationen in das RAM in vorteilhafter Weise,insbesondere im Zusammenhang mit einer Änderung der Tarifdaten, nutzbar zu machen, besteht das Schaltglied zur Unterbindung eines Schreibeffektes beispielsweise aus einem plombierbaren Schalter, mittels welchem im Normalbetrieb des Taxameters das "Write"-Signal sperrbar ist, für einen Programmierbetrieb jedoch freigebbar ist. Letzterer Vorgang beschränkt sich z. B. auf eine Eingabe neuer oder geänderter Tarifdaten, die auszuführen ausschließlich einem hierfür autorisierten Personenkreis vorbehalten bleibt. Aufgrund der Veränderbarkeit der Tarifdaten über geeignete Schaltglieder in der Steuerschaltung lassen sich somit ohne jeden Aufwand von neuen Teilen beliebig oft Tarifumstellungen durchführen. Zur Freigabe der "Schreibsperrschaltung" bei einer erforderlichen Tarifdatenänderung kann auch ein Code-Schaltwerk eingesetzt werden. Schließlich können auch anstelle des Codeschaltwerkes geeignete optisch oder magnetisch wirksame Einrichtungen eingesetzt werden, um für den Fall einer erforderlichen Tarifdatenänderung eine Einflußnahme auf die Steuerschaltung zu gewähren.

Ein Ausführungsbeispiel der Schaltungsanordnung gemäß der Erfindung ist nachfolgend beschrieben und in Zeichnungen dargestellt.

Es zeigt

FIG. 1 ausschnittsweise eine schematisierte Schaltungsanordnung eines Mikrocomputersystems für Taxameter mit einer Schaltungseinrichtung zur Sicherung von Tarifdaten in einem volatilen Speicher (RAM),

FIG. 2 eine schematisierte Schaltungsanordnung gemäß FIG. 1 mit einer Schaltungseinrichtung zur Sicherung von in bestimmtem Adressbereich eines volatilen Speichers (RAM) abgelegten Tarifdaten.

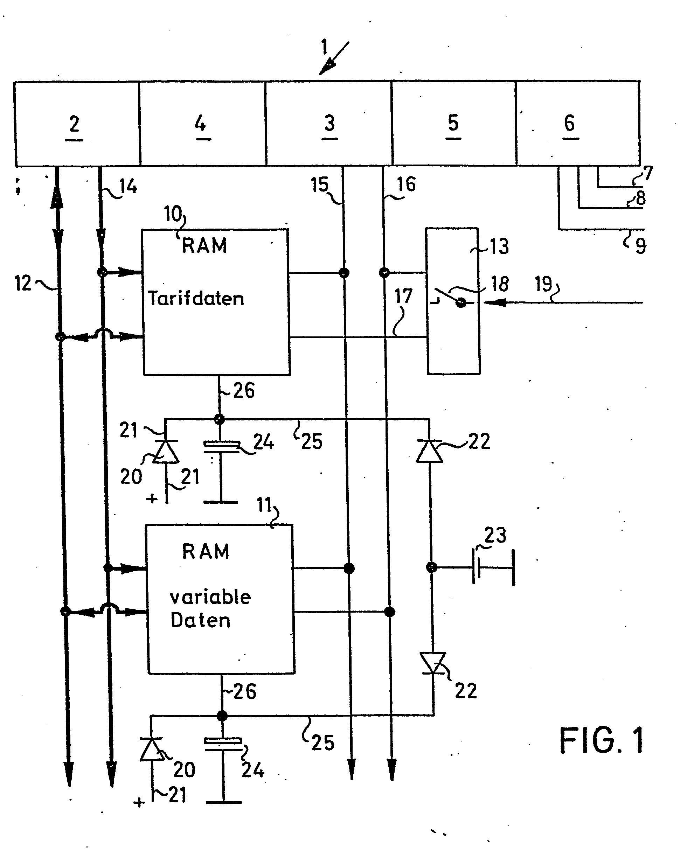

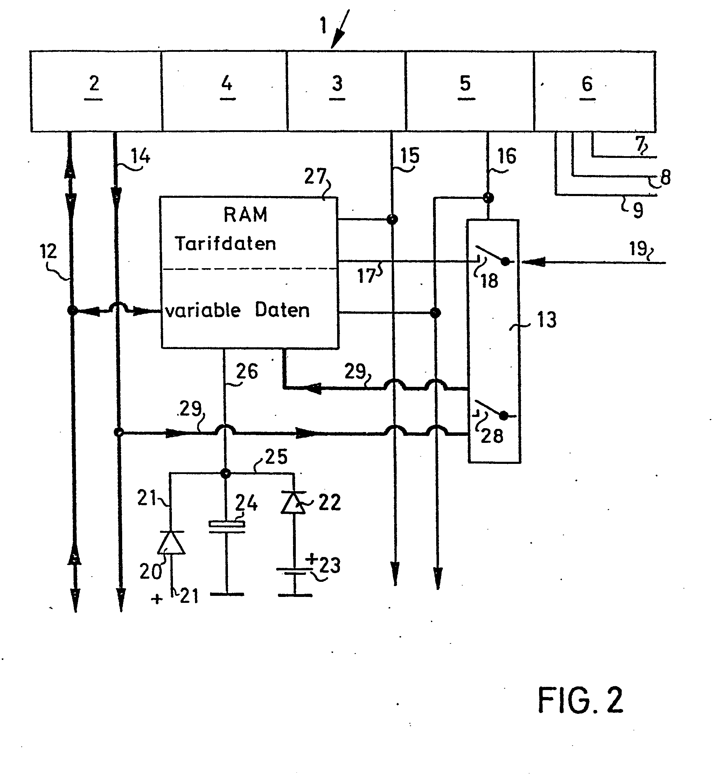

Der Gegenstand der Erfindung bezieht sich auf einen elektronischen Taxameter und hier speziell auf den Bereich der Speicherung von Tarif- und Kontrolldaten und deren Absicherung gegen unzulässige Veränderung dieser Daten durch Systemstörungen oder versuchter Manipulation. Im wesentlichen besteht ein elektronischer Taxameter aus einem Mikrocomputersystem 1, das sich in der Regel aus einem Mikroprozessor 2 oder CPU (Central Processor Unit), einem Programmspeicher 3 oder ROM (Read-only Memory), einem Schreib-Lese-Speicher 4 oder RAM (Random Access Memory), einer Steuereinheit 5 oder BUS CONTROL und einem Taktgenerator 6 oder CLOCK zusammensetzt. Entsprechend der funktionellen Bedeutung und der gerätebaulichen Zusammenhänge sind die erforderlichen Bauelemente in Baugruppen zusammengefaßt und hardwaremäßig auf entsprechend ausgelegten, nicht näher erklärten Leiterplatten angeordnet. Diese Leiterplatten sind über geeignete Steckverbindungen miteinander verbindbar, wodurch gleichzeitig möglichst alle erforderlichen leitenden Verbindungen zwischen den Baugruppen herstellbar sind. Eine nähere Darstellung aller Baugruppen ist für die Erläuterung der Zusammenhänge der erfindungsgemäßen Schaltungsanordnung nicht erforderlich, weshalb sie auch nur andeutungsweise erklärt sind. Funktionelle Entscheidungen, Rechenvorgänge, Steuerungsabläufe, Speicherung von Daten usw. werden bei einem elektronischen Taxameter in der mit dem Begriff "Logik" zu bezeichnenden Baugruppe abgewickelt. Kernstück der Logik ist, wie in FIG. 1 dargestellt, das Mikrocomputersystem 1 mit dem Zentralen Mikroprozessor 2 oder CPU als dem die Funktionsabläufe ausführenden Bauelement. Zur Versorgung mit Betriebsspannung ist das Mikrocomputersystem 2 über eine Leitung 7 mit einem den Erfordernissen angepaßten, nicht näher gezeigten Netzteil verbunden. Zur Darstellung der Vorgänge, insbesondere zur laufenden Anzeige von Ergebnissen, Speicherdaten, Kontrollzählerdaten und anderer für den Taxameterbetrieb bedeutsamer Informationen werden die entsprechend aufgerufenen Daten über einen Displaybus 8 in einem nach Gesichtspunkten der Bedeutung der Daten geordneten, mehrstelligen Anzeigefeld dargestellt. Schließlich erhält das Mikrocomputersystem 1 über eine Gebersignalleitung 9 durch eine nicht näher gezeigte Geber-Eingangsschaltung entsprechend aufbereitete Signale, die beispielsweise als Wegstreckeneinheiten zur Umrechnung in Fahrpreiseinheiten in Anwendung vorgegebener Rechenregeln in der Logik ausgewertet werden. Bekanntlich gehen neben den Wegstreckeneinheiten auch Zeiteinheiten in eine Berechnung einer Fahrpreiseinheit ein. Die Entscheidung, welche der beiden Einheiten in der Form eines Signalzuges oder ob beide Signalfrequenzen in bestimmter Relation zueinander für die Preisbildung herangezogen werden, trifft die Logik aufgrund eines durch die betreffende Tarifstruktur bestimmten Arbeitsprogrammes. Basis einer Fahrpreiseinheit ist, wie ebenfalls bekannt ist, der für die örtlichen Verhältnisse festgelegte Tarif. Aufgrund dieser Forderung und zusätzlich aufgrund der ständigen Anpassung der Fahrpreise an die ständig steigenden Kostenforderungen muß das Taxametergerät bzgl. des Hardware-Bereiches an jede vorgegebene Tarifsituation anpassungsfähig sein. Als besonders geeignet für die Einspeicherung von Tarifdaten sowie die wiederholte Änderung dieser Daten in gewissen Zeitabständen hat sich der als flüchtiger Schreib-Lese-Speicher 10 oder RAM auf dem Markt befindliche Speicherbaustein erwiesen, sofern es gelingt, durch Zusatzeinrichtungen eine absolute Sicherung der im RAM abgelegten Tarifdaten zu erzielen. Eine Sicherungsmaßnahme ist dabei sowohl auf den normalen Störfall, wie Systemstörungen oder Netzspannungsausfälle, als auch auf den versuchten Störfall durch Manipulation der gespeicherten Daten im Normalbetrieb des Taxameters auszudehnen. Das RAM 1o ist getrennt vom zentralen Mikrocomputersystem 1 als Tarifdatenspeicher funktionell, wie in FIG. 1 und 2 gezeigt ist, mit allen Daten-, Adress- und Steuerleitungen an das Mikrocomputersystem 1 angeschlossen. Gemäß einer Ausführungsform nach FIG. 1 ist eigens für die Speicherung der Tarifdaten ein RAM 1o vorgesehen, entsprechend ist für die Aufnahme von ständig variablen Daten, wie sie beispielsweise die Kontrollzählerdaten darstellen, ein RAM 11 angeordnet. Über einen bidirektionalen Datenbus 12 erfolgt, gesteuert durch das Steuerwerk im Mikrocomputersystem 1, der Datenfluß zwischen letzterem (1) und dem aufgerufenen Speicher RAM 1o oder 11. Während das RAM 11 im Normalbetrieb des Taxameters durch Steuerungssignale aus dem Mikrocomputerbereich 1 wahlweise entsprechend dem Arbeitsprogramm auf Schreib- oder Lesevorgänge schaltbar ist, bleibt die Funktion des RAM 1o lediglich auf die Bereitstellung der abgelegten Tarifdaten für den Auslesevorgang beschränkt. Im Ausnahmefall, das ist der Fall einer beabsichtigten Änderung der Tarifdaten, ist auch das RAM 1o durch die Betätigung einer im folgenden noch zu erläuternden Steuerschaltung 13 für einen Einschreibvorgang einstellbar. Für die Auswahl der auszulesenden Daten bzw. für die Einspeicherung dar abzulegenden Daten sind die RAM 1o und 11 über einen Adressbus 14 mit dem Mikrocomputersystem 1 verbunden. Über die interne Steuereinheit 5 oder Controlbus und eine Read-Signalleitung 15 sowie eine Write-Signalleitung 16 werden entsprechende Signale für Lesen bzw. Schreiben in das RAM 10 geführt. Für die Überleitung eines Schreibsignales (Write-Signal) in das ausschließlich für Tarifdaten bestimmte RAM 10 ist die Write-Signalleitung 16 über eine Steuerschaltung 13 und eine Write-Verbindungsleitung 17 mit dem RAM 10 verbunden. Aufgrund der Steuerschaltung 13 ist es möglich, durch zusätzliche Schaltungsmittel in der Steuerschaltung 13 ausschließlich über eine vom System getrennte Einflußnahme auf die Steuerschaltung 13 ein beabsichtigtes Write-Signal in das RAM 10 gelangen zu lassen. Durch die Zwischenschaltung der Steuerschaltung 13 ist für den Normalbetrieb eines Taxameters eine permanente Unterdrückung des "Schreibkommandos", welches sich in der einfachsten Form als "Write-Impuls" auf einer Signalleitung 16 zum RAM 10 darstellt, einstellbar. Damit ist absolut verhindert, daß das System in irgendeiner Form die als Tarifdaten im RAM 10 abgelegten Daten verändern kann. Zur Beschränkung der Einflußnahme auf die Steuerschaltung 13 auf einen hierzu autorisierten Kreis enthält die Steuerschaltung 13 beispielsweise einen plombierbaren Schalter 18, welcher ein Einschreibsignal für das RAM 10 unterbricht oder aber ein Sperrsignal erzeugt, durch welches jeder Informationsfluß in das RAM 10 unterbunden wird. Im Sinne der Erschwerung einer Einflußnahme auf die Steuerschaltung 13 kann auch ein Code-Schaltwerk vorgesehen sein, über welches ein Schalter 18 zur Herstellung der Verbindung der "Write"-Signalleitung mit dem RAM 10 steuerbar ist. In einer weiteren Ausführungsform ist es denkbar, mittels einer optischen Einrichtung die Steuerschaltung 13 zu beeinflussen, um das Beschreiben des Tarif-RAM 10 mit neuen Tarifdaten zu ermöglichen. In einer weiteren Ausbildung der Steuerschaltung 13 ist das Laden des Tarif-RAM 10 auch über magnetische Steuerungsmittel und der Anwendung von Reed-Schaltern durchführbar.

Die verschiedentlich angegebenen Arten der äußeren Einwirkung auf die Steuerschaltung 13 im Sinne einer vorgegebenen Tarifdatenänderung sind gemäß FIG. 1 und 2 durch eine Leitung 19 angedeutet.

Für die Speicherung der variablen Kontrolldaten ist gemäß der Ausführungsform nach FIG. 1 ein weiterer Schreib-Lese-Speicher (RAM) 11 vorgesehen, der zur Ein- und Auslesung von Daten ebenfalls über den Datenbus 12 und Adressbus 14 mit dem Mikrocomputersystem 1 verbunden ist. Bei einer Speicherung von variablen Kontrolldaten sind für eine laufende Modifikation der Speicherinhalte die "Write"- 16 und "Read"-Signalleitung 15 direkt mit der Bus-Control-Einheit 5 verbunden. Zur Versorgung der RAM 1o und 11 mit Betriebsspannung sind zur Sicherstellung der Spannungsversorgung bzw. zum Schutz gegen irgendwelche Betriebsspannungseinbrüche jeweils eine Entkopplungsdiode 2o in der Leitung 21 zur Systembetriebsspannungsquelle vorgesehen. Eine weitere Entkopplungsdiode 22 liegt jeweils in der nach FIG. 1 angegebenen Spannungsversorgungsleitung aus einer Pufferbatterie 23. Schließlich enthält die Schaltungsanordnung zur Entkopplung und Pufferung der Versorgungsspannung einen Pufferkondensator 24, der einerseits an Masse und mit seinem zweiten Anschluß mit den Spannungsversorgungsleitungen 21 und 25 sowie über eine Leitung 26 mit dem RAM 10 und 11 zur ständigen Versorgung bzw. Aufrechterhaltung der Speicher mit Betriebsspannung verbunden sind.

In einer anderen Ausführungsform der Schaltungsanordnung gemäß der Erfindung ist gemeinsam für die Speicherung von Tarifdaten und variablen Daten (z. B. Kontrollzählerdaten) ein einziger Schreib-Lese-Speicher-(RAM)-Baustein 27 verwendet (FIG. 2). Das RAM 27 ist zur Erfüllung von Speicherungsaufgaben einerseits von gesicherten Tarifdaten und andererseits von variablen Kontrollzählerdaten in entsprechend erforderliche Speicherbereiche aufgeteilt. Um auch hier im gleichen Maße die absolute Sicherung der Tarifdaten gegen unerlaubte Veränderungen zu erzielen, ist die Steuerschaltung 13 dahingehend erweitert, daß zusätzliche Schaltglieder 28 vorgesehen sind, durch welche bestimmte, der Speicherung von Tarifdaten zugeordnete Adressbereiche im RAM 27 für ein fehlerhaftes Beschreiben sperrbar sind. Zu diesem Zweck ist der Adressbus 14 bezüglich der Signalleitungen 29 für die Speicheradressierung für Tarifdaten über die Steuerschaltung 13 geführt, wo durch die Schaltglieder 29 entsprechende Speicherbereiche ansprechbar sind. In dem durch die Schaltglieder 28 blockierbaren Speichersektor sind im plombierten Zustand des Taxameters die Speicherplätze zwar lesbar, jedoch nicht beschreibbar, so daß im Zusammenwirken mit der in gleicher Steuerschaltung 13 angeordneten Schreibsignal-Sperre die dort abgelegten Tarifdaten nicht veränderbar sind. Eine Veränderung ist ausschließlich, wie schon zu FIG. 1 erläutert, im Sinne einer durch autorisierte Stellen vornehmbaren, äußeren Einwirkung durch Einflußnahme über eine Leitung 19 möglich. Bezüglich der Sicherungsmaßnahmen gegen Verfälschungen des Informationsinhaltes des RAM 27 auf der Grundlage eines Spannungseinbruches oder Verlustes gelten für die gemäß der FIG. 2 angezeigte Schaltungsanordnung sinngemäß die gleichen Maßnahmen wie sie für die Schaltung nach FIG. 1 erklärt wurden.

0085117
26.1.1982
o73 sche zw
Akte 1755

Patentansprüche:

1. Schaltungsanordnung zur Sicherung von Daten, insbesondere von Tarifdaten und/oder variablen Kontrolldaten in als flüchtige (volatile) Speicher ausgebildeten Schreib-Lese-Speichern (RAM) im Zusammenwirken mit einem mittels Pufferelementen gegen Versorgungsspannungseinbrüche geschützten Mikrocomputersystem eines Taxameters gegen Manipulation und Verlust oder unerlaubte Modifikation der gespeicherten Informationen,
gekennzeichnet
durch eine in die Signalleitung zwischen dem Mikrocomputersystem (1) und dem Schreib-Lese-Speicher (RAM) (1o, 27) einbezogene Steuerschaltung (13), mittels welcher im kalibrierten Zustand des Gerätes eine Unterdrückung von Einschreib-Befehlen einstellbar ist, derart daß der Erhalt der abgelegten Daten im RAM (1o, 27) gewährleistet ist.

2. Schaltungsanordnung nach Anspruch 1,
gekennzeichnet
durch eine Steuerschaltung (13) zwischen dem Mikrocomputersystem (1) und einem Schreib-Lese-Speicher (RAM) (27) für die Speicherung von Tarifdaten und gleichzeitig für eine Aufnahme von variablen Daten, mittels welcher im verplombten Zustand über einstellbare Schaltglieder (28) die Beschreibmöglichkeit des RAM (27) in einem bestimmten Adressbereich unterbindbar ist.

3. Schaltungsanordnung nach den Ansprüchen 1 und 2,
dadurch gekennzeichnet,
daß eine Schaltung (2o bis 26) zur Entkopplung der Betriebsspannung des Mikrocomputersystems (1) vom Schreib-Lese-Speicher (RAM) (1o, 11, 27) und Schaltelemente (23, 24) zur Pufferung einer Betriebsspannung für das RAM (1o, 11, 27) vorgesehen sind, dergestalt daß im normalen Betriebszustand des Gerätes Veränderungen der Betriebsspannung des Mikrocomputersystems (1) permanent ohne Einfluß auf die gespeicherten Informationen des RAM (1o, 11,
27) bleiben.

4. Schaltungsanordnung nach den Ansprüchen 1 bis 3,
dadurch gekennzeichnet,
daß zur Bereitstellung einer Betriebsspannung für das RAM
(1o, 11, 27) für Tarifdaten und variable Daten eine Pufferbatterie (23) vorgesehen ist, die über eine Entkopplungsdiode (22) einen Pufferkondensator (24) auflädt.

5. Schaltungsanordnung nach Anspruch 1,
dadurch gekennzeichnet,
daß die Steuerschaltung (13) einstellbare Schalter bzw.
einstellbare Schaltglieder (18, 28) enthält, durch deren
eine für den Betrieb des Taxameters gesicherte Funktionsposition bestimmte, vorgebbare Signale vom Mikrocomputersystem in das RAM (11, 27) leitbar sind, und ein Datenabruf aller gespeicherten Informationen für den Betrieb des
Taxameters aus jedem RAM (1o, 11, 27) initiierbar ist,
eine Veränderung der abgelegten Tarifdaten durch entsprechend einstellbare Einschreibunterdrückung permanent sperrbar ist.

6. Schaltungsanordnung nach Anspruch 2,
dadurch gekennzeichnet,
daß die Steuerschaltung (13) Schalter bzw. Schaltglieder
(18 und 28) enthält, mit welchen eine Unterdrückung von
Schreibbefehlen für bestimmte Adressbereiche eines mit
konstanten Tarifdaten und variablen Kontrolzählerdaten
aufladbaren RAM (27) einstellbar ist.

7. Schaltungsanordnung nach den Ansprüchen 1, 2, 5 und 6,
dadurch gekennzeichnet, daß der Schalter (18) und das Schaltglied (28) plombierbare Schaltermittel sind, mittels welchen Steuer- und/
oder Sperrsignale zur Unterdrückung von Schreibbefehlen
und eine Blockierung von Adressenleitungen für den Bereich eines Tarifdatenspeichers in einem RAM (1o bzw. 27)
initiierbar sind.

8. Schaltungsanordnung nach den Ansprüchen 1, 2, 5, 6 und 7,
dadurch gekennzeichnet,
daß die Steuerschaltung (13) ein Code-Schaltwerk enthält,
mit welchem ein Signal zur Steuerung des Schalters (18)
bzw. Schaltgliedes (28) initiierbar ist.

FIG. 1

FIG. 2

# 0085117

## EUROPÄISCHER RECHERCHENBERICHT

Nummer der Anmeldung

**EP 82 10 0587**

Europäisches Patentamt

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| A | FR-A-2 489 031 (MARCEL VICTOR FAY) *Insgesamt* | 1,2,5-8 | G 11 C 7/00 G 11 C 8/00 G 06 F 12/14 |
| A | PATENTS ABSTRACTS OF JAPAN, Band 4, Nr. 1, 8. Januar 1980, Seite 107 E 163 & JP - A - 54 142 025 (TOKYO SHIBAURA) (11.05.1979) | 1 | |
| A | PATENTS ABSTRACTS OF JAPAN, Band 2, Nr. 156, 26. Dezember 1978, Seite 10.242E78 & JP - A - 53 126 827 (TOKYO SHIBAURA) (11.06.1978) | 1 | |
| A | IBM TECHNICAL DISCLOSURE BULLETIN, Band 20, Nr. 8, Januar 1978, Seiten 3259-3260, New York (USA); R.D.PELLINGER et al.: "Dual addressable memory". *Insgesamt* | 1,5,7,8 | **RECHERCHIERTE SACHGEBIETE (Int. Cl. 3)** |
| A | COMPUTER DESIGN, Band 18, Nr. 8, März 1979, Seiten 117-123, Winchester (USA); D.C.YOUNG: "Guidelines for designing battery backup circuits for CMOS RAMS". *Seite 121, Zeile 12 bis Seite 122, rechte Spalte, Zeile 27; Figuren 6-11* | 3 | G 11 C 7/00 G 11 C 5/00 G 11 C 8/00 G 06 F 12/14 |

-/-

Der vorliegende Recherchenbericht wurde für alle Patentansprüche erstellt.

| Recherchenort | Abschlußdatum der Recherche | Prüfer |
|---|---|---|
| DEN HAAG | 14-10-1982 | DEGRAEVE L.W.G. |

EPA Form 1503 03.82

| | Europäisches Patentamt | EUROPÄISCHER RECHERCHENBERICHT | | |

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | US-A-3 703 710 (HITACHI) *Insgesamt* | 1 | |
| | --- | | |
| A | PATENTS ABSTRACTS OF JAPAN, Band 5, Nr. 201, 19. Dezember 1981, Seite (P-94)(873); & JP - A - 56 123 048 (HITACHI SEISAKUSHO K.K.) (26.09.1981) *Insgesamt* | 1 | |
| | --- | | |
| A | IBM TECHNICAL DISCLOSURE BULLETIN, Band 18, Nr. 2, Juli 1975, Seite 374-375, New York (USA); R.H.HOHENSEE et al.: "Subsystem write control". *Insgesamt* | 1 | |
| | ----- | | |

RECHERCHIERTE SACHGEBIETE (Int. Cl. ³)

Der vorliegende Recherchenbericht wurde für alle Patentansprüche erstellt.

| Recherchenort | Abschlußdatum der Recherche | Prüfer |
|---|---|---|
| DEN HAAG | 14-10-1982 | DEGRAEVE L.W.G. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, jerein- stimmendes Dokument

EPA Form 1503. 03.82